# EUROPÄISCHE PATENTSCHRIFT

(11) **EP 3 671 869 B1**
(45) Veröffentlichungstag und Bekanntmachung des Hinweises auf die Patenterteilung: **06.07.2022**
(21) Anmeldenummer: 19218665.8
(22) Anmeldetag: 20.12.2019
(51) Int. Cl.: H01L 33/62, H01R 33/09

(54) **LICHTQUELLE, INSBESONDERE FÜR EIN MEDIZINISCHES UNTERSUCHUNGSGERÄT, MIT KANÄLEN IN EINEM GRUNDKÖRPER UND MONTAGEVERFAHREN FÜR EINE LICHTQUELLE**
LIGHT SOURCE, IN PARTICULAR FOR A MEDICAL EXAMINATION DEVICE, WITH CHANNELS IN A BASE BODY AND MOUNTING METHOD FOR A LIGHT SOURCE
SOURCE LUMINEUSE, EN PARTICULIER POUR UN APPAREIL D'EXAMEN MÉDICAL, DOTÉE DES CANAUX DANS UN CORPS DE BASE ET PROCÉDÉ DE MONTAGE POUR UNE SOURCE LUMINEUSE

(30) Priorität: 21.12.2018 DE 202018005897 U; 08.04.2019 DE 102019109205
(43) Veröffentlichungstag der Anmeldung: 24.06.2020
(73) Patentinhaber: Kirchner & Wilhelm GmbH + Co. KG, 71679 Asperg (DE)
(72) Erfinder: Kirchner-Gottschalk, Regina, 71706 Markgröningen (DE)
(74) Vertreter: Kohler Schmid Möbus Patentanwälte

(56) Entgegenhaltungen:
- EP-A1- 1 112 721
- DE-A1- 19 649 650
- US-A- 5 057 982

## Beschreibung

Die Erfindung betrifft eine Lichtquelle, insbesondere für ein medizinisches Untersuchungsgerät,
umfassend eine LED-Baugruppe und eine Basis-Baugruppe, an der die LED-Baugruppe befestigt ist,
wobei die LED-Baugruppe eine LED sowie ein erstes metallisches Anschlussbein, insbesondere für eine Anode der LED, und ein zweites metallisches Anschlussbein, insbesondere für eine Kathode der LED, umfasst,
und wobei die Basis-Baugruppe einen Grundkörper umfasst.

Eine solche Lichtquelle ist beispielsweise bekannt geworden durch die Firmendruckschrift "tradition & future continuous innovation" der Kirchner & Wilhelm GmbH + Co. KG, Asperg, DE, Jahrgang 2017, Seite 191.

Lichtquellen werden in verschiedensten Anwendungen benötigt, um lokal in einer dunklen, beispielsweise abgeschatteten Umgebung Licht bereitzustellen. Beispielsweise werden bei der Untersuchung von Körperöffnungen wie dem Gehörgang von Ärzten Untersuchungsgeräte wie Otoskope eingesetzt, die das für die Untersuchung notwendige Licht zur Verfügung stellen. In der Vergangenheit wurden dafür kleine Glühbirnen eingesetzt; mittlerweile ist der Einsatz von Lichtquelle auf Basis von Leuchtdioden (englisch light emitting diodes, abgekürzt LEDs) eingesetzt.

LEDs als solche sind in verschiedenen Bauformen zahlreich verfügbar; sie bestehen in der Regel aus einem transparenten Kunststoffkörper, in welchen der lichterzeugende pn-Übergang integriert ist, und aus welchem zwei metallische Anschlussbeine herausragen.

In vielen Anwendungen werden LEDs aber nicht direkt verbaut, sondern die LED wird in eine Lichtquelle (auch als "Lampe" bezeichnet) verbaut, und diese Lichtquelle wird dann wiederum in einem Anwendungsgerät verbaut.

Die aus der Firmendruckschrift von Kirchner & Wilhelm bekannten Lampen weisen einen im Wesentlichen rohrförmigen metallischen Grundkörper auf, in den die LED einenends eingeschoben ist. Anderenends ist ein leicht konisches Kunststoffröhrchen in den metallischen Grundkörper eingeschoben, wobei zwischen der Innenwand des metallischen Grundkörpers und einer Außenwand des Kunststoffröhrchens das Kathoden-Anschlussbein der LED verklemmt ist. Dadurch wird das Kathoden-Anschlussbein elektrisch mit dem metallischen Grundkörper verbunden. In das Kunststoffröhrchen ist wiederum eine metallische Kontaktnadel eingeschoben, wobei zwischen einer Innenwand des Kunststoffröhrchens und der metallischen Kontaktnadel das Anoden-Anschlussbein der LED eingeklemmt ist. Dadurch wird das Anoden-Anschlussbein elektrisch mit der metallischen Kontaktnadel verbunden. Der im Inneren des Grundkörpers verlaufende Teile des Anoden-Anschlussbeins der LED ist mit einer Kunststoffhülle versehen, um einen elektrischen Kurzschluss mit dem metallischen Grundkörper zu verhindern.

Die solchermaßen aufgebaute Lichtquelle kann gut in verschiedenen Anwendungsgeräten wie medizinischen Untersuchungsgeräten eingesetzt werden, wobei sie von außen über den metallischen Grundkörper und die metallische Kontaktnadel gut elektrisch kontaktiert und mechanisch gehalten werden kann.

Eine weitere Lampe aus dem Stand der Technik ist in der Schrift EP 1 112 721 A1 offenbart.

Nachteilig an der solchermaßen aufgebauten Lichtquelle ist jedoch, dass sie aufwändig und schwierig zu montieren ist. Zunächst muss das Anoden-Anschlussbein mit der Kunststoffhülle versehen werden. Dann muss das Anoden-Anschlussbein in das Kunststoffröhrchen eingeführt werden. Anschließend muss das Kunststoffröhrchen in den Grundkörper eingeschoben werden, wobei das Kathodenanschlussbein verklemmt werden muss, gleichzeitig darf das Anoden-anschlussbein nicht aus dem Kunststoffröhrchen rutschen. Schließlich muss die Kontaktnadel in das Kunststoffröhrchen eingeführt werden, wobei das Anoden-anschlussbein verklemmt werden muss. Diese teilweise hoch filigranen Montageschritte müssen von sorgfältig geschulten und besonders fingerfertigen Werkerinnen und Werkern manuell durchgeführt werden; die Tätigkeit erfordert ein hohes Maß an Konzentration der Werkerinnen und Werker, so dass bei Erschöpfung eine nicht unerhebliche Gefahr von Fehlmontagen besteht.

Durch die 2E mechatronic GmbH & Co. KG, Kircheimunter Teck, DE, sind so genannte UNC-LED-Leuchtelemente bekannt geworden, vgl. https://www.2e-mechatronic.de/de/produkt/unc-led-leuchtelemente/, heruntergeladen am 28.2.2019. Hierbei wird auf einer ebenen Innenseite eines Kunststoffeinsatzes ein Leiterschema aufgedruckt und eine elektrische Konstantstromquellen-Schaltung aufgelötet. Das Leiterschema umfasst einen ersten zentralen Leiter, der in ein C-förmig offenes Fußteil des Kunststoffeinsatzes führt, und einen zweiten Leiter, der auf eine Außenseite des Kunststoffeinsatzes führt. In nicht näher ersichtlicher weise wird eine LED in den Kunststoffeinsatz eingeführt und elektrisch angeschlossen, vermutlich durch verlöten. Über den Kunststoffeinsatz wird ein rohrförmiges, mit einem endseitigen Gewinde versehenes Messing-Hüllelement gefügt, wobei das Fußteil das endseitige Gewinde durchragt. Diese Leuchtelemente sind vergleichsweise aufwändig zu fertigen und erfordern dafür besondere Anlagen, insbesondere zum Aufdrucken des Leiterschemas auf den Kunststoffkörper und für alle Auflötprozesse. Zudem ist die Kontaktierung des zentralen Leiters am Fußteil schwierig.

### Aufgabe der Erfindung

Es ist Aufgabe der Erfindung, eine Lichtquelle zur Verfügung zu stellen, die einfach aufgebaut und einfach zu montieren ist.

### Beschreibung der Erfindung

Diese Aufgabe wird erfindungsgemäß gelöst durch eine Lichtquelle der eingangs genannten Art, die dadurch gekennzeichnet ist,
dass der Grundkörper aus einem elektrisch isolierenden Material, insbesondere Kunststoff, gefertigt ist und einen ersten Kanal sowie einen zweiten Kanal aufweist,
dass der erste Kanal eine vordere Kanalöffnung an einer Oberseite des Grundkörpers aufweist, wobei die Oberseite der LED zugewandt ist, und eine hintere Kanalöffnung an einer Unterseite des Grundkörpers aufweist, wobei die Unterseite der LED abgewandt ist,
dass der zweite Kanal eine vordere Kanalöffnung ebenfalls an der Oberseite des Grundkörpers aufweist, und eine hintere Kanalöffnung an einer Seitenfläche des Grundkörpers aufweist, wobei die Seitenfläche zwischen oder Oberseite und der Unterseite ausgebildet ist,
und dass das erste Anschlussbein in den ersten Kanal und das zweite Anschlussbein in den zweiten Kanal eingesteckt ist.

Bei der erfindungsgemäßen Lichtquelle (Lampe) wird ein besonders ausgebildeter Grundkörper der Basis-Baugruppe eingesetzt. Dieser Grundkörper ist mit zwei Kanälen ausgebildet, in die die Anschlussbeide der LED-Baugruppe von der Oberseite her bzw. von den vorderen Kanalöffnungen aus eingesteckt (eingeführt) sind. Die Kanäle bilden jeweils in Umfangsrichtung geschlossene und voneinander getrennte Hohlräume im Grundkörper aus. Durch die Kanäle werden die Anschlussbeine der LED-Baugruppe bei der Montage (also beim Einstecken) im Grundkörper zuverlässig geführt und im eingesteckten Zustand definiert positioniert. Das Einstecken der Anschlussbeine in die Kanäle ist einfach und kann manuell auch von Werkerinnen und Werkern mit nur geringer Fingerfertigkeit durchgeführt werden. Im eingesteckten Zustand werden die Anschlussbeine durch den Grundköper zuverlässig voneinander elektrisch isoliert, da der Grundkörper aus einem elektrischen Isolator-Material gefertigt ist.

Als Material für den Grundkörper ist Kunststoff gut geeignet, da Kunststoff kostengünstig ist und sich leicht mit der gewünschten Geometrie des Grundkörpers fertigen lässt, etwa durch Spitzguss. Falls gewünscht, können die Kanäle auch durch Bohren gefertigt werden (etwa dann, wenn der Grundkörper aus einem Keramikmaterial gefertigt wird, um beispielsweise eine höhere Temperaturbeständigkeit einzurichten).

Für ein elektrisches Kontaktieren der Anschlussbeine können die Anschlussbeine aus der jeweiligen hinteren Kanalöffnung herausragen, oder von der hinteren Kanalöffnung aus im jeweiligen Kanal direkt oder indirekt kontaktiert werden. Eine typische elektrische Kontaktierung sieht ein Verklemmen des Anschlussbeins mit einer metallischen Struktur (etwa einem Metallring oder einer metallischen Kontaktnadel) vor, die wiederum mit einer Fassung eines Anwendungsgeräts kontaktiert werden kann. Ebenso ist es möglich, dass das Anschlussbein im Bereich der hinteren Kanalöffnung für eine Berührung freiliegt, bevorzugt wobei das Anschlussbein elastisch federnd in der Lichtquelle angeordnet ist; das freiliegende Anschlussbein kann wiederum mit einer Fassung eines Anwendungsgeräts kontaktiert werden. Durch die Anordnung der hinteren Kanalöffnung des ersten Kanals an einer Unterseite des Grundkörpers, und die Anordnung der hinteren Kanalöffnung des zweiten Kanals an einer Seitenfläche des Grundkörpers, kann eine gute räumliche Trennung der elektrischen Kontaktierungen der beiden Pole (Anode und Kathode) der LED der LED-Baugruppe erfolgen, und die Gefahr von elektrischen Kurzschlüssen ist sehr gering.

Man beachte, dass ein Anschlussbein der LED-Baugruppe, das in einen Kanal eingesteckt ist, unmittelbar durch ein LED-Anschlussbein ausgebildet sein kann. Es ist aber auch möglich, dass ein Anschlussbein der LED-Baugruppe, das in einen Kanal eingesteckt ist, über ein elektrisches Bauteil mit einem LED-Anschlussbein verbunden ist.

Die Form und Größe des Grundkörpers kann je nach Anwendungsfall flexibel gewählt werden. Typischerweise ist der Grundkörper im Wesentlichen zylinderförmig und bevorzugt mit einem kreisrunden Querschnitt ausgebildet; es ist aber auch möglich, einen beispielsweise rechteckigen oder ovalen Querschnitt des Grundkörpers zu wählen.

Man beachte, dass etwaige weitere Elemente der Basis-Baugruppe, etwa ein Metallring oder eine Metallnadel, typischerweise für mehrere Formen und/oder Größen, und insbesondere für verschiedene Längen, von Grundkörpern universell eingesetzt werden können, was die Herstellungskosten niedrig hält.

Die erfindungsgemäße Lichtquelle kann insbesondere für medizinische Untersuchungsgeräte wie Otoskope, Ophthalmoskope, Dermatoskope, Mundleuchten usw. eingesetzt werden; es ist aber auch möglich, die Lichtquelle anderweitig, insbesondere für nicht-medizinische Geräte und Anwendungen, einzusetzen.

### Bevorzugte Ausführungsformen

Bevorzugt ist eine Ausführungsform der erfindungsgemäßen Lichtquelle, bei der die Basis-Baugruppe weiterhin einen Metallring umfasst, der zumindest auf einen Teil der Seitenfläche aufgeschoben ist, insbesondere aufgepresst ist, wobei zwischen der Seitenfläche und einer Innenseite des Metallrings ein Endabschnitt des zweiten Anschlussbeins eingeklemmt ist. Mit dem Metallring kann eine robuste elektrische Kontaktierung des zweiten Anschlussbeins (typischerweise damit der Kathode) erfolgen, die über den gesamten Umfang gut zugänglich ist. Die Form des Metallrings richtet sich nach der Form des Grundkörpers im Bereich der Seitenfläche. Typischerweise ist der Metallring kreisringförmig ausgebildet; es ist aber auch möglich, beispielsweise einen rechteckig-ringförmigen Metallring oder einen oval-ringförmigen Metallring einzusetzen (bei entsprechender Form des Grundkörpers).

Bei einer alternativen, vorteilhaften Ausführungsform ist vorgesehen, dass am Grundkörper eine seitliche Hilfsausnehmung ausgebildet ist, und dass das zweite Anschlussbein mit einem Endabschnitt aus der hinteren Kanalöffnung des zweiten Kanals herausragt, und der Endabschnitt des zweiten Anschlussbeins weiterhin in die seitliche Hilfsausnehmung eingesteckt ist, wobei ein Teil des Endabschnitts des zweiten Anschlussbeins zwischen der hinteren Kanalöffnung des zweiten Kanals und der seitlichen Hilfsausnehmung freiliegt. Dadurch kann eine besonders einfache elektrische Kontaktierung des zweiten Anschlussbeins erfolgen, die kein zusätzliches Bauteil der Basis-Baugruppe benötigt. Der freiliegende Teil des Endabschnitts liegt bevorzugt zwischen der hinteren Kanalöffnung und der seitlichen Hilfsausnehmung mit etwas Abstand vor der Seitenwand, so dass dieser Teil in radialer Richtung für eine elektrische Kontaktierung (etwa durch eine Fassung des Anwendungsgeräts) etwas federn kann.

Bevorzugt ist auch eine Ausführungsform, bei der die Basis-Baugruppe weiterhin eine Metallnadel umfasst, die in die hintere Kanalöffnung des ersten Kanals eingeschoben ist, insbesondere eingepresst ist, wobei zwischen der Metallnadel und einer Innenseite des ersten Kanals ein Endabschnitt des ersten Anschlussbeins eingeklemmt ist. Mit der Metallnadel kann eine besonders robuste elektrische Kontaktierung des ersten Anschlussbeins (typischerweise damit der Anode) erfolgen; die Metallnadel kann auch als "Kontaktnagel" bezeichnet werden. Typischerweise weitet sich bei dieser Bauform der erste Kanal zur hinteren Kanalöffnung hin auf, um einen Nadelaufnahmeraum für die Metallnadel auszubilden, und die hintere Kanalöffnung des ersten Kanals bzw. dieser Nadelaufnahmeraum für die Metallnadel ist zentral im Grundkörper ausgebildet.

Bei einer alternativen, vorteilhaften Ausführungsform ist vorgesehen, dass am Grundkörper eine untere Hilfsausnehmung ausgebildet ist, und dass das erste Anschlussbein mit einem Endabschnitt aus der hinteren Kanalöffnung des ersten Kanals herausragt, und der Endabschnitt des ersten Anschlussbeins weiterhin in die untere Hilfsausnehmung eingesteckt ist, wobei ein Teil des Endabschnitts des ersten Anschlussbeins zwischen der hinteren Kanalöffnung des ersten Kanals und der unteren Hilfsausnehmung freiliegt. Dadurch kann eine besonders einfache elektrische Kontaktierung des ersten Anschlussbeins erfolgen, die kein zusätzliches Bauteil der Basis-Baugruppe benötigt. Der freiliegende Teil des Endabschnitts liegt bevorzugt zwischen der hinteren Kanalöffnung und der unteren Hilfsausnehmung mit etwas Abstand vor der Unterseite, so dass dieser Teil in axialer Richtung für eine elektrische Kontaktierung (etwa durch eine Fassung des Anwendungsgeräts) etwas federn kann.

Bevorzugt ist weiterhin eine Ausführungsform, bei der im Grundkörper hinter der LED eine Aufnahme-Ausnehmung ausgebildet ist, wobei die Aufnahme-Ausnehmung durch die LED zumindest teilweise abgedeckt ist,
insbesondere wobei die vordere Kanalöffnung des ersten Kanals und die vordere Kanalöffnung des zweiten Kanals in die Aufnahme-Ausnehmung münden. Die Aufnahme-Ausnehmung kann als Bauraum für ein Elektronik-Bauteil (oder auch mehrere Elektronik-Bauteile) dienen, um die Lichtquelle in einer gewünschten Weise zu ertüchtigen. Die Aufnahme-Ausnehmung ist bevorzugt (bei montierter LED, und abgesehen von den Kanalöffnungen) geschlossen ausgebildet; es ist aber auch möglich, für eine Materialersparnis oder auch für die Einrichtung von mechanischen Eigenschaften am Grundkörper die Aufnahme-Ausnehmung nur teilweise zu umschließen, etwa mit axial ausgreifenden Fingern. Der Grundkörper bildet einen gewissen mechanischen Schutz für das Innere der Aufnahme-Ausnehmung aus.

Bevorzugt ist auch eine Ausführungsform, die vorsieht,
dass die LED-Baugruppe weiterhin ein Elektronik-Bauteil umfasst, insbesondere wobei das Elektronik-Bauteil als Konstantstromquellen-Schaltung oder als Vorwiderstand ausgebildet ist,
und dass das Elektronik-Bauteil zwischen der LED und wenigstens einem der Anschlussbeine angeschlossen ist. Mit dem Elektronik-Bauteil (oder auch mehreren Elektronik-Bauteilen kann die Lichtquelle besonders ertüchtigt werden, insbesondere durch einen Vorwiderstand für eine bestimmte Eingangsspannung (etwa einer Batterie-Stromquelle) oder durch eine Konstantstromquellen-Schaltung für eine konstante Leuchtstärke (auch wenn die Eingangsspannung etwas schwanken sollte, etwa wenn eine Batterie-Stromquelle beginnt sich zu erschöpfen). Das Elektronik-Bauteil kann auf einer Platine aufgebaut sein, insbesondere wenn das Elektronik-Bauteil als Konstantstromquellen-Schaltung ausgebildet ist. Eine Konstantstromquellen-Schaltung kann eine Zehnerdiode umfassen.

Bei einer bevorzugten Weiterbildung ist das Elektronik-Bauteil in der Aufnahme-Ausnehmung angeordnet. Dadurch ist das Elektronik-Bauteil bei der Montage leicht unterzubringen und mechanisch gut geschützt.

Bei einer anderen Weiterbildung Lichtquelle ist das Elektronik-Bauteil in einem der Kanäle angeordnet ist, insbesondere wobei das Elektronik-Bauteil als Vorwiderstand ausgebildet ist. Durch die Anordnung des Elektronik-Bauteils in einem der Kanäle kann die Baugröße der Lichtquelle gering gehalten werden, insbesondere in axialer Richtung. Das Elektronik-Bauteil ist hierbei typischerweise nur mit einem der Anschlussbeine der LED-Baugruppe (und auch nur einem LED-Anschlussbein) verbunden. Für einen Vorwiderstand wird in der Regel nur sehr wenig Platz benötigt, so dass dieser gut in einem Kanal angeordnet werden kann.

Besonders bevorzugt ist eine Ausführungsform, bei der der Grundkörper eine Führungsaufnahme, insbesondere becherförmige Führungsaufnahme, für die LED ausbildet, in die die LED eingeschoben ist, insbesondere eingepresst ist. Die Führungsaufnahme begrenzt in radialer Richtung (zumindest teilweise) einen Raum, in welchen die LED bei der Montage der Lichtquelle eingeschoben wird; bevorzugt wird die LED dabei auch verklemmt und dadurch im eingeschobenen Zustand fixiert. Typischerweise bildet die Führungsaufnahme auch einen axialen Anschlag für die LED aus, was eine definierte Montage erleichtert. Die Oberseite, in der die vorderen Kanalöffnungen münden, kann als der Grund der becherförmigen Führungsaufnahme ausgebildet sein, wobei dieser Grund gleichzeitig einen Anschlag für die LED ausbildet. Alternativ kann die Führungsaufnahme oberhalb einer Aufnahme-Ausnehmung für ein Elektronik-Bauteil ausgebildet sein; in diesem Fall ist meist ein schulterförmiger Anschlag für die LED vorgesehen.

Bei einer vorteilhaften Ausführungsform ist die LED an einen vorderen, der LED zugewandten Teil des Grundkörpers auf den Grundkörper aufgeklebt. Dies ist eine einfache und kostengünstige Form der Fixierung, die auch mit einfach aufgebauten Grundkörpern leicht eingerichtet werden kann.

Besonders bevorzugt ist eine Ausführungsform, bei der an einem hinteren, der LED abgewandten Teil des Grundkörpers ein Außengewinde ausgebildet ist. Dadurch kann die Lichtquelle durch Einschrauben an einem Anwendungsgerät auf einfache Weise durch Einschrauben an einer Gewinde-Fassung fixiert werden.

Vorteilhaft ist zudem eine Ausführungsform, bei der der erste Kanal und der zweite Kanal unter einem Winkel von 45° oder weniger, bevorzugt unter einem Winkel von 30° oder weniger, zueinander verlaufen. Dadurch wird das gleichzeitige Einstecken (Einführen) des ersten und zweiten Anschlussbeins der LED-Baugruppe besonders einfach, und die Anschlussbeine erfahren keine oder nur wenig elastische und/oder plastische Verformung. Typischerweise verlaufen die Kanäle näherungsweise in einer axialen Richtung des Grundkörpers.

### Erfindungsgemäße Verfahren zur Montage einer Lichtquelle

In den Rahmen der vorliegenden Erfindung fällt auch ein Verfahren zur Montage einer Lichtquelle, insbesondere einer erfindungsgemäßen, oben beschriebenen Lichtquelle, mit folgenden Schritten:
a) eine LED-Baugruppe, umfassend eine LED sowie ein erstes metallisches Anschlussbein, insbesondere für eine Anode der LED, und ein zweites metallisches Anschlussbein, insbesondere für eine Kathode der LED, wird vor einem Grundkörper aus einem elektrisch isolierenden Material, insbesondere aus Kunststoff, positioniert,
   wobei der Grundkörper einen ersten Kanal und einen zweiten Kanal aufweist, wobei der erste Kanal und der zweite Kanal an einer Oberseite des Grundkörpers jeweils vordere Kanalöffnungen aufweisen, und der erste Kanal eine hintere Kanalöffnung an einer Unterseite des Grundkörpers aufweist, die der Oberseite gegenüber liegt, und der zweite Kanal eine hintere Kanalöffnung an einer Seitenfläche des Grundkörpers aufweist, die zwischen der Oberseite und der Unterseite ausgebildet ist;
b) ein Endabschnitt des ersten Anschlussbeins wird in die vordere Kanalöffnung des ersten Kanals eingefädelt, und ein Endabschnitt des zweiten Anschlussbeins wird in die vordere Kanalöffnung des zweiten Kanals eingefädelt;
c) die LED-Baugruppe und der Grundkörper werden aufeinander zu bewegt, so dass das erste Anschlussbein in den ersten Kanal und gleichzeitig das zweite Anschlussbein in den zweiten Kanal eingeschoben wird. Das erfindungsgemäße Zusammenfügen von LED-Baugruppe und Basis-Baugruppe ist sehr einfach, und erfordert lediglich das Einfädeln der beiden Anschlussbeine der LED-Baugruppe in die vorderen Kanalöffnungen der beiden Kanäle und ein Zusammenschieben von LED-Baugruppe und Basis-Baugruppe, was jeweils einfach möglich ist. Bevorzugt entspricht ein Abstand der Endabschnitte der beiden Anschlussbeine vor Schritt b) in einem unverformten Zustand näherungsweise einem Abstand der vorderen Kanalöffnungen der Kanäle an der Oberseite (Vorderseite) des Grundkörpers, so dass die Anschlussbeide (elastisch und/oder plastisch) nicht verformt werden müssen, um das Einfädeln zu bewerkstelligen. Beim weiteren Einschieben führen die Kanäle die Anschlussbeine in ihrem Inneren bis zu einer für etwaige weitere Montageschritte oder die weitere Verwendung vorgesehenen Endposition.

Bevorzugt ist eine Variante des erfindungsgemäßen Verfahrens, die vorsieht, dass nach Schritt c) der Endabschnitt des zweiten Anschlussbeins aus der hinteren Kanalöffnung des zweiten Kanals herausragt,
und dass weiterhin vorgesehen ist ein Schritt
d) ein Metallring wird zumindest auf einen Teil der Seitenfläche des Grundkörpers aufgeschoben, insbesondere aufgepresst, wobei der Endabschnitt des zweiten Anschlussbeins zwischen der Seitenfläche und einer Innenseite des Metallrings eingeklemmt wird. Dadurch kann der Metallring, der elektrisch leitfähig ist, für eine Kontaktierung des zweiten Anschlussbeins (in der Regel die Kathode) genutzt werden. Der Metallring ist robust und ist über den gesamten Umfang leicht zugänglich. Ein etwaiger über den Metallring herausragender Überstand des zweiten Anschlussteils wird entfernt, etwa abgeschnitten, um Verletzungsgefahr und Kurzschlussrisiko zu minimieren.

Bei einer alternativen Variante ist vorgesehen,
dass nach Schritt c) der Endabschnitt des zweiten Anschlussbeins aus der hinteren Kanalöffnung des zweiten Kanals herausragt,
und dass weiterhin vorgesehen ist ein Schritt
d') der Endabschnitt des zweiten Anschlussbeins, der aus der hinteren Kanalöffnung des zweiten Kanals herausragt, wird in eine seitliche Hilfsausnehmung des Grundkörpers eingesteckt, wobei ein Teil des Endabschnitts des zweiten Anschlussbeins zwischen der hinteren Kanalöffnung des zweiten Kanals und der seitlichen Hilfsausnehmung freiliegend bleibt. Der freiliegende Teil kann für eine elektrische Kontaktierung des zweiten Anschlussbeins einfach kontaktiert werden, ohne dass es einen weiteren Bauteils der Basis-Baugruppe bedarf. Bevorzugt steht der freiliegende Teil etwas gegenüber der Seitenwand des Grundkörpers hervor (und liegt nicht an der Seitenwand an), so dass der freiliegende Teil in radialer Richtung etwas federn kann.

Bevorzugt ist weiterhin eine Variante, bei der weiterhin vorgesehen ist ein Schritt
e) eine Metallnadel wird in die hintere Kanalöffnung des ersten Kanals eingeschoben, insbesondere eingepresst, wobei der Endabschnitt des ersten Anschlussbeins zwischen der Metallnadel und der Innenseite des ersten Kanals eingeklemmt wird,
insbesondere wobei nach Schritt c) der Endabschnitt des ersten Anschlussbeins aus der hinteren Kanalöffnung des ersten Kanals herausragt, und nach Schritt
e) ein aus der hinteren Kanalöffnung herausragender Teil des Endabschnitts des ersten Anschlussbeins entfernt wird, bevorzugt abgeschnitten wird. Mit der Metallnadel ist ein mechanisch robuster elektrischer Kontakt zum ersten Anschlussbein möglich; typischerweise sitzt die Metallnadel mittig an der Unterseite des Grundkörpers. Der herausragende Teil des Endabschnitts erleichtert das Einklemmen des Endabschnitts, beispielsweise kann der Endabschnitt beim Einschieben der Metallnadel festgehalten werden. Durch das Entfernen bzw. Abschneiden des Überstands bei eingeschobener Metallnadel wird die Verletzungsgefahr bei der Verwendung, etwa beim Einsetzen der Lichtquelle in ein Anwendungsgerät, minimiert, und ebenso die Kurzschlussgefahr minimiert.

Bevorzugt ist zudem eine alternative Variante, die vorsieht, dass nach Schritt c) der Endabschnitt des ersten Anschlussbeins aus der hinteren Kanalöffnung des ersten Kanals herausragt,
und dass weiterhin vorgesehen ist ein Schritt
e') der Endabschnitt des ersten Anschlussbeins, der aus der hinteren Kanalöffnung des ersten Kanals herausragt, wird in eine untere Hilfsausnehmung des Grundkörpers eingesteckt, wobei ein Teil des Endabschnitts des ersten Anschlussbeins zwischen der hinteren Kanalöffnung des ersten Kanals und der unteren Hilfsausnehmung freiliegend bleibt. Der freiliegende Teil kann für eine elektrische Kontaktierung des ersten Anschlussbeins einfach kontaktiert werden, ohne dass es einen weiteren Bauteils der Basis-Baugruppe bedarf. Bevorzugt steht der freiliegende Teil etwas gegenüber der Unterseite des Grundkörpers hervor (und liegt nicht an der Unterseite an), so dass der freiliegende Teil in axialer Richtung etwas federn kann.

Bei einer vorteilhaften Variante werden in Schritt c) die LED-Baugruppe und der Grundkörper aufeinander zu bewegt, bis die LED-Baugruppe, insbesondere mit der LED, auf einen Anschlag des Grundkörpers trifft. Dadurch kann eine gewünschte Endposition genau definiert und exakt eingestellt werden, insbesondere auch manuell. Alternativ kann auch ein bestimmter Relativweg zwischen LED-Baugruppe und Grundkörper/Basisbaugruppe angewandt werden, was vor allem bei automatisierter (also nicht-manueller) Montage in Frage kommt.

Vorteilhaft ist auch eine Variante, bei der in Schritt c) die LED in eine Führungsaufnahme, insbesondere becherförmige Führungsaufnahme, des Grundkörpers eingeschoben wird, insbesondere eingepresst wird. Dadurch wird die relative Position von Grundkörper/Basis-Baugruppe und LED/LED-Baugruppe definiert vorgegeben und exakt eingestellt werden. Zudem wird ein mechanisch robuster Aufbau erreicht. Bei gegenseitiger Verklemmung von LED und Grundkörper mittels der Führungsaufnahme wird keine Fixierung durch Kleben benötigt, was die Montage vereinfacht und beschleunigt; insbesondere muss kein Aushärten von Kleber in einer einstweilen mit Hilfsmittels zu fixierender Relativposition abgewartet werden.

Es ist in einer anderen Variante aber auch möglich, dass eine am Ende von Schritt c) erreichte relative Position von Grundkörper und LED-Baugruppe durch Kleben fixiert wird, insbesondere durch Aufkleben der LED auf einen vorderen Teil des Grundkörpers. Fixieren durch Kleben ist kostengünstig und erfordert keine besonders ausgebildeten, zueinander passenden Formen für die LED und den Grundkörper.

Weitere Vorteile der Erfindung ergeben sich aus der Beschreibung und der Zeichnung. Ebenso können die vorstehend genannten und die noch weiter ausgeführten Merkmale erfindungsgemäß jeweils einzeln für sich oder zu mehreren in beliebigen Kombinationen Verwendung finden. Die gezeigten und beschriebenen Ausführungsformen sind nicht als abschließende Aufzählung zu verstehen, sondern haben vielmehr beispielhaften Charakter für die Schilderung der Erfindung.

### Detaillierte Beschreibung der Erfindung und Zeichnung

- Fig. 1: zeigt in schematischen Längsschnitten eine erste Ausführungsform einer erfindungsgemäßen Lichtquelle, mit Führungsaufnahme für die LED;
- Fig. 2: zeigt in schematischen Längsschnitten eine zweite Ausführungsform einer erfindungsgemäßen Lichtquelle, mit einer Aufnahme-Ausnehmung für ein Elektronik-Bauteil;
- Fig. 3: zeigt in schematischen Längsschnitten eine dritte Ausführungsform einer erfindungsgemäßen Lichtquelle, mit einer Führungsaufnahme für die LED und einer Aufnahme-Ausnehmung für ein Elektronik-Bauteil;
- Fig. 4: zeigt in einem schematischen Längsschnitt un einer schematischen Perspektivansicht eine vierte Ausführungsform einer erfindungsgemäßen Lichtquelle, wobei ein zweites Anschlussbein in eine seitliche Hilfsausnehmung eingesteckt ist;
- Fig. 5: zeigt in einer Folge von schematischen Längsschnitten eine erste Variante eines erfindungsgemäßen Verfahrens zur Montage einer Lichtquelle, mit Anbringung eines Metallrings und einer Kontaktnadel;
- Fig. 6: zeigt in einer Folge von schematischen Längsschnitten eine zweite Variante eines erfindungsgemäßen Verfahrens zur Montage einer Lichtquelle, mit Einstecken von Endabschnitten von erstem Anschlussbein und zweitem Anschlussbein in eine untere Hilfsausnehmung und eine seitliche Hilfsausnehmung.

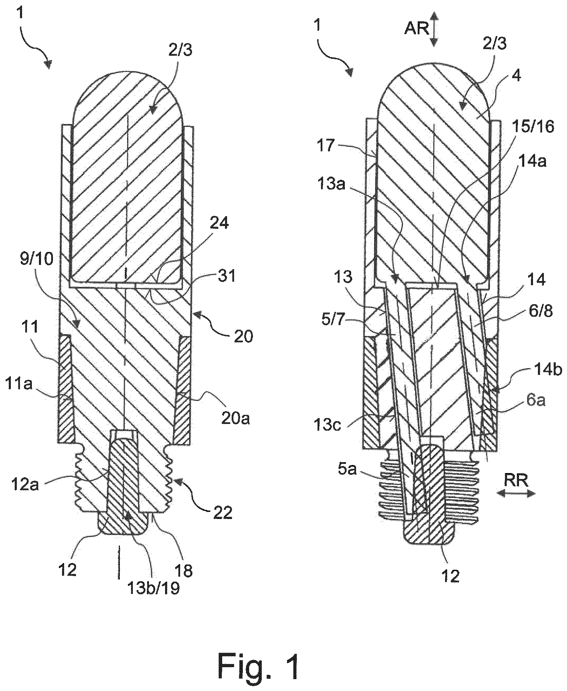

Die **Fig. 1** zeigt in zwei schematischen Längsschnitten eine erste Ausführungsform einer erfindungsgemäßen Lichtquelle 1, wobei der rechts gezeigte Schnitt in einer Ebene, der den ersten und zweiten Kanal enthält, liegt, und der links gezeigt Schnitt in einer dazu um 90° um eine axiale Richtung AR gedrehten Ebene.

Die Lichtquelle 1 umfasst eine LED-Baugruppe 2, die hier lediglich aus einer LED 3 besteht. Die LED-Baugruppe 2 weist ein erstes Anschlussbein 5 und ein zweites Anschlussbein 6 auf. Das erste Anschlussbein 5 der LED-Baugruppe 2 stellt hier gleichzeitig das erste Anschlussbein 7 der LED 3 dar, und das zweite Anschlussbein 6 der LED-Baugruppe 2 stellt hier gleichzeitig das zweite Anschlussbein 8 der LED 3 dar. Die LED 3 verfügt über einen transparenten Kunststoffkörper 4, in dem der lichtemittierende pn-Übergang der LED 3 eingebettet ist, und die Anschlussbeine 7, 8 der LED 3 ragen unterseitig aus dem Kunststoffkörper 4 heraus.

Die Lichtquelle 1 umfasst weiterhin eine Basis-Baugruppe 10, die einen Grundkörper 9 aus einem elektrisch isolierenden Material, hier einem Kunststoff wie Polyethylen, sowie hier weiterhin einem Metallring 11 und einer Metallnadel 12 umfasst. Der Grundkörper 9 ist hier im Wesentlichen zylinderförmig mit einem runden Querschnitt ausgebildet.

In dem Grundkörper 9 ist ein erster Kanal 13 ausgebildet, in welchen das erste Anschlussbein 5 der LED-Baugruppe 2 eingesteckt ist, und weiterhin ein zweiter Kanal 14 ausgebildet, in welchen das zweite Anschlussbein 6 der LED-Baugruppe 2 eingesteckt ist. Die Kanäle 13, 14 verlaufen hier zueinander parallel (also unter einem Winkel von 0° zueinander) im Grundkörper 9 und sind gegen die axiale Richtung AR hier um ca. 8° geneigt. Am Allgemeinen ist es bevorzugt, wenn die Kanäle 13, 14 zueinander unter einem Winkel von 45° oder weniger, besonders bevorzugt 30° oder weniger, verlaufen, und typischerweise verlaufen auch die Kanäle 13, 14 jeweils unter einem Winkel von 45° oder weniger, bevorzugt 30° oder weniger, zur axialen Richtung AR.

An einer der LED 3 zugewandten Oberseite 15 des Grundkörpers 9, hier ausgebildet durch den Grund 16 einer Führungsaufnahme 17 für die LED 3 bzw. deren Kunststoffkörper 4, sind vordere, nebeneinander liegende Kanalöffnungen 13a, 14a des ersten Kanals 13 und des zweiten Kanals 14 ausgebildet. Mit der hier becherförmigen Führungsaufnahme 17 wird die LED 3 bzw. die LED-Baugruppe 2 sicher im Grundkörper 9 bzw. an der Basis-Baugruppe 10 gehalten, hier im Presssitz. Der Grund 16 bildet dabei einen Anschlag 31 für die Rückseite 24 der LED 3 beim Einführen der LED 3 in die Führungsaufnahme 17 aus (in der schematischen Darstellung ist für eine bessere Erkennbarkeit der Bauteile ein kleiner verbleibender Spalt eingezeichnet).

An einer Unterseite 18 des Grundkörpers 9 ist eine hintere Kanalöffnung 13b des ersten Kanals 13 ausgebildet, wobei hier die hintere Kanalöffnung 13b zu einem Nadelaufnahmeraum 19 für die Metallnadel 12 erweitert ist. Das erste Anschlussbein 5 der LED-Baugruppe 2 ist mit einem Endabschnitt 5a zwischen einer Innenseite 13c des ersten Kanals und einer Außenseite 12a der Metallnadel 12 eingeklemmt (Man beachte, dass in Fig. 1 das erste Anschlussbein 5 zur Vereinfachung "voll" dargestellt ist, also ohne die plastische Verformung aufgrund des Klemmens).

An einem hier leicht konisch verlaufenden Teil 20a einer Seitenfläche 20 des Grundkörpers 9 ist eine hintere Kanalöffnung 14b des zweiten Kanals 14 ausgebildet. Auf diesem Teil 20a der Seitenfläche 20 ist der Metallring 11 angeordnet. Dabei wird ein Endabschnitt 6a des zweiten Anschlussbeins 6 der LED-Baugruppe 2 zwischen einer Innenseite 11a des Metallrings 11 und der Seitenfläche 20 des Grundkörpers 9 eingeklemmt.

Am hinteren Teil des Grundkörpers 9 ist hier ein Außengewinde 22 ausgebildet, mit dem die Lichtquelle 1 in eine Fassung eines Anwendungsgeräts eingeschraubt werden kann. Das Außengewinde besitzt einen etwas kleineren Radius als der übrige Grundkörper 9, vgl. die radiale Richtung RR. Die elektrische Kontaktierung der Lichtquelle 1 erfolgt über die Metallnadel 12 hier zur Anode und über den Metallring 11 hier zur Kathode der LED 3.

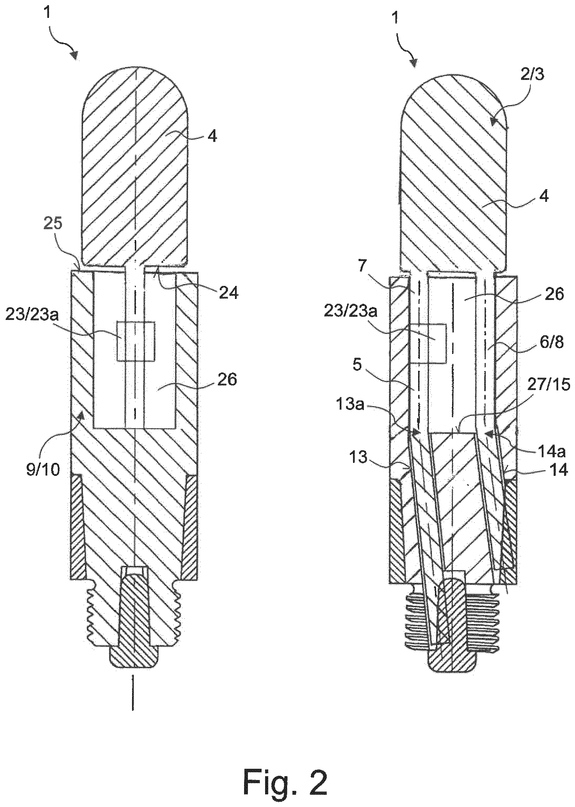

Die **Fig. 2** zeigt eine zweite Ausführungsform einer erfindungsgemäßen Lichtquelle 1, die der Ausführungsform von Fig. 1 in weiten Teilen entspricht; es werden daher nur die wesentlichen Unterschiede zur Bauform von Fig. 1 erläutert.

Bei dieser Bauform weist die LED-Baugruppe 2 ein Elektronik-Bauteil 23, hier einen Vorwiderstand 23a, auf. Die LED 3 ist hier mit ihrem ersten Anschlussbein 7 an das Elektronik-Bauteil 23 angeschlossen. Weiterhin ist das erste Anschlussbein 5 der LED-Baugruppe 2 an das Elektronik-Bauteil 23 angeschlossen. Das Anschlussbein 5 der LED-Baugruppe 5 ist in den ersten Kanal 13 eingesteckt. Das zweite Anschlussbein 8 der LED 3 stellt wiederum gleichzeitig das erste Anschlussbein 6 der LED-Baugruppe 2 dar und ist in den zweiten Kanal 14 eingesteckt.

Die LED 3 sitzt hier mit der Unterseite 24 ihres Kunststoffkörpers 4 auf einer Ringfläche 25 vorne am Grundkörper 9 auf (in der schematischen Darstellung ist für eine bessere Erkennbarkeit der Bauteile ein kleiner verbleibender Spalt eingezeichnet); typischerweise ist die LED 3 dabei auf der Ringfläche 25 aufgeklebt. Hinter der LED 3 ist im Grundkörper 9 eine Aufnahme-Ausnehmung 26 ausgebildet, die durch die LED 3 (in Fig. 2 nach oben hin) abgedeckt wird. Mit der Aufnahme-Ausnehmung 26 kann das Elektronik-Bauteil 23 leicht in der Leichtquelle 1 untergebracht werden. Die vorderen Kanalöffnungen 13a, 14a sind hier in einem Grund 27 der Aufnahme-Ausnehmung 26 ausgebildet, wobei der Grund 27 einen Teil der Oberseite 15 des Grundkörpers 9 bildet, der der LED 3 bzw. deren Kunststoffkörper 4 zugewandt ist.

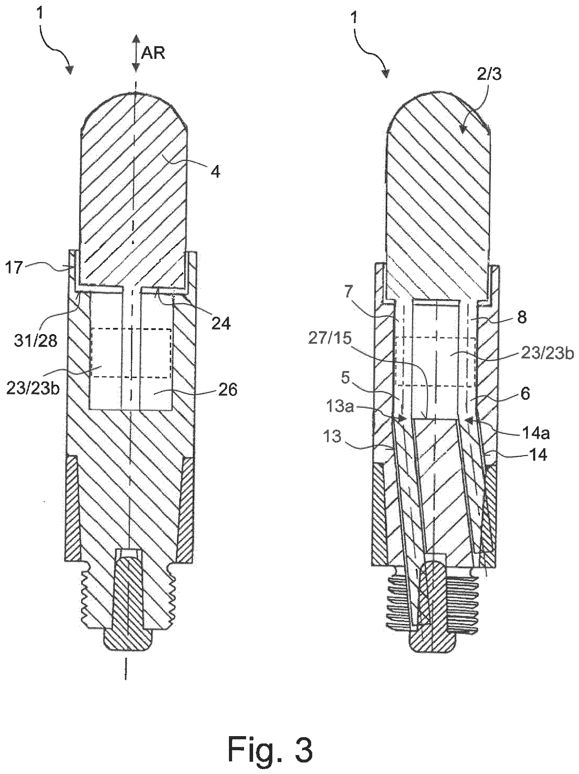

Die **Fig. 3** zeigt eine dritte Ausführungsform einer erfindungsgemäßen Lichtquelle 1, die der Ausführungsform von Fig. 1 in weiten Teilen entspricht; es werden daher nur die wesentlichen Unterschiede zur Bauform von Fig. 1 erläutert.

Bei dieser Bauform weist die LED-Baugruppe 2 ein Elektronik-Bauteil 23, hier eine Konstantstromquellen-Schaltung 23b, auf. Die LED 3 ist hier mit ihrem ersten Anschlussbein 7 und mit ihrem zweiten Anschlussbein 8 an das Elektronik-Bauteil 23 angeschlossen. Weiterhin sind das erste Anschlussbein 5 und das zweite Anschlussbein 6 der LED-Baugruppe 2 an das Elektronik-Bauteil 23 angeschlossen. Das Anschlussbein 5 der LED-Baugruppe 5 ist in den ersten Kanal 13 eingesteckt, und das Anschlussbein 6 der LED-Baugruppe 2 ist in den zweiten Kanal 14 eingesteckt.

Die LED 3 sitzt hier mit der Unterseite 24 ihres Kunststoffkörpers 4 auf einer Schulter 28 des Grundkörpers 9 auf (in der schematischen Darstellung ist für eine bessere Erkennbarkeit der Bauteile ein kleiner verbleibender Spalt eingezeichnet); die Schulter 28 begrenzt in axialer Richtung AR eine Führungsaufnahme 17 für die LED 3 bzw. deren Kunststoffkörper 4, wirkt entsprechend also als ein axialer Anschlag 31. Die LED 3 ist in die Führungsaufnahme 17 eingepresst und fixiert dadurch die LED 3 bzw. die LED-Baugruppe 2 am Grundkörper 9. Hinter der LED 3, und damit hinter der Schulter 28, ist im Grundkörper 9 wiederum eine Aufnahme-Ausnehmung 26 ausgebildet, die durch die LED 3 (in Fig. 3 nach oben hin) abgedeckt wird. Durch die Aufnahme-Ausnehmung 26 kann das Elektronik-Bauteil 23 leicht in der Lichtquelle 1 untergebracht werden. Die vorderen Kanalöffnungen 13a, 14a sind hier in einem Grund 27 der Aufnahme-Ausnehmung 26 ausgebildet, wobei der Grund 27 einen Teil der Oberseite 15 des Grundkörpers 9 bildet, der der LED 3 bzw. deren Kunststoffkörper 4 zugewandt ist.

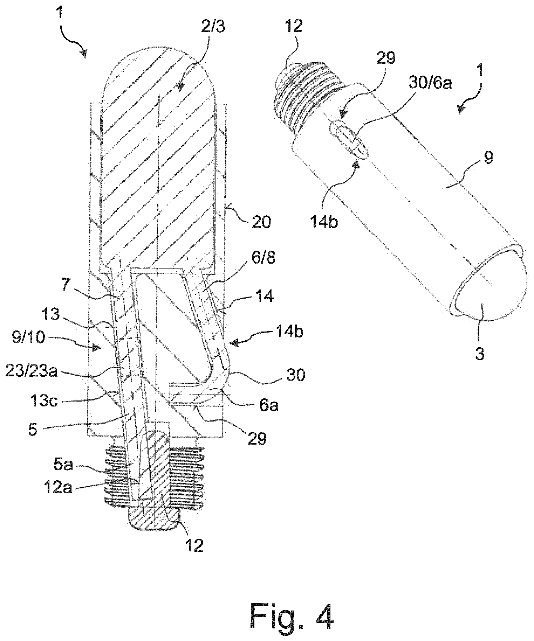

Die **Fig. 4** zeigt eine vierte Ausführungsform einer erfindungsgemäßen Lichtquelle 1, die der Ausführungsform von Fig. 1 in weiten Teilen entspricht; es werden daher nur die wesentlichen Unterschiede zur Bauform von Fig. 1 erläutert. Links ist ein Längsschnitt, der die Kanäle 13, 14 enthält, dargestellt, und rechts ist eine schematische Perspektivansicht dargestellt.

Bei dieser Bauform umfasst die Basis-Baugruppe 10 lediglich den Grundkörper 9 und die Metallnadel 12. Der Endabschnitt 5a des ersten Anschlussbeins 5 ist zwischen der Innenseite (Wand) 13c des ersten Kanals 13 und der Außenseite 12a der Metallnadel 12 eingeklemmt.

Hingegen ist an der Seitenfläche 20 des Grundkörpers 9 das zweite Anschlussbein 6 der LED-Baugruppe 2 aus der hinteren Kanalöffnung 14b herausgeführt und mit einem Endabschnitt 6a in eine seitliche Hilfsausnehmung 29 eingesteckt, die axial hinter (in Fig. 4 links unter) der hinteren Kanalöffnung 14b liegt. Dabei steht ein Teil 30 des Endabschnitts 14b gegenüber der Seitenfläche 20 über und liegt frei.

Die LED-Baugruppe 2 umfasst zudem hier ein Elektronik-Bauteil 23, nämlich einen Vorwiderstand 23a, der zwischen dem ersten Anschlussbein 7 der LED 3 und dem ersten Anschlussbein 5 der LED-Baugruppe 2 angeschlossen ist. Der Vorwiderstand 23a ist ausreichend klein, so dass er in den ersten Kanal 13 mit eingeschoben werden konnte.

Die elektrische Kontaktierung der Lichtquelle 1 erfolgt über die Metallnadel 12 hier zur Anode und über den freiliegenden Teil 30 des Endabschnitts 6a hier zur Kathode der LED 3.

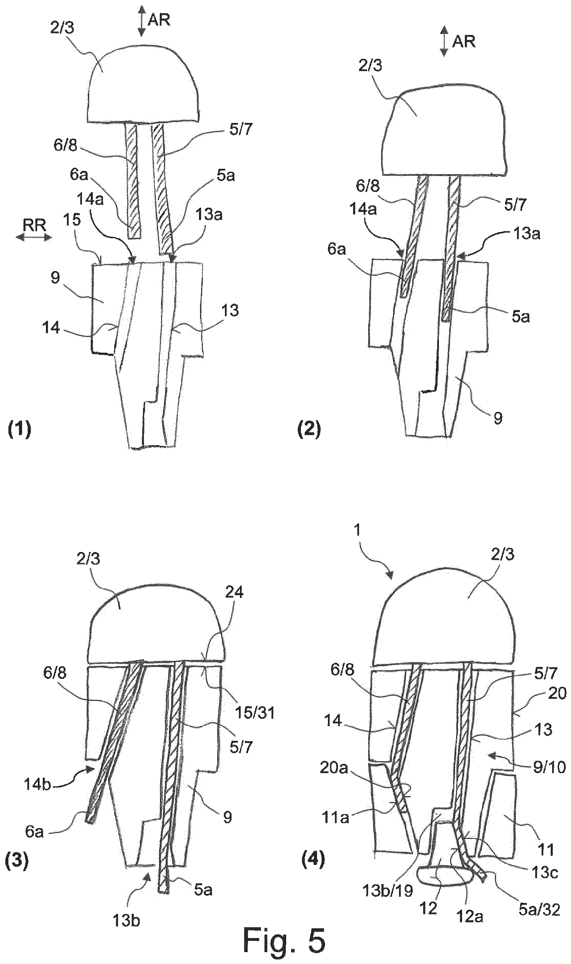

Die **Fig. 5** erläutert in anhand einer Folge von Teilabbildungen (1), (2), (3) und (4) eine erste Variante eines erfindungsgemäßen Verfahrens zur Montage einer Lichtquelle gemäß der Erfindung, insbesondere einer erfindungsgemäßen Lichtquelle wie beispielsweise in den Fig. 1, Fig. 2, Fig. 3 oder Fig. 4 dargestellt; die in Fig. 5 dargestellte Lichtquelle ist dabei entsprechend beispielhaft zu verstehen, und erläutert Montageschritte im Falle der Verwendung von Metallring und/oder Metallnadel.

In einem ersten Schritt a), dargestellt in Teilabbildung (1), wird zunächst die LED-Baugruppe 2, hier lediglich umfassend die LED 3, (axial) vor dem Grundkörper 9 aus elektrisch isolierendem Material angeordnet. Der Grundkörper 9 weist den ersten Kanal 13 und den zweiten Kanal 14 auf. Die vorderen Kanalöffnungen 13a, 14a an der Oberseite 15 des Grundkörpers 9 sind dem ersten und zweiten Anschlussbein 5, 6 der LED-Baugruppe 2 zugewandt; die jeweiligen (radialen) Abstände der vorderen Kanalöffnungen 13a, 14a und der Anschlussbeine 5, 6 (zumindest an deren unteren Endabschnitten 5a, 6a) sind näherungsweise gleich.

In einem zweiten Schritt b) werden die Anschlussbeine 5, 6 bzw. deren Endabschnitte 5a, 6a in die vorderen Kanalöffnungen 13a, 14a eingefädelt. Der Zustand nach gelungenem Einfädeln ist in Teilabbildung (2) dargestellt. Hierfür wurden bereits die LED-Baugruppe 2 und der Grundkörper 9 etwas entlang der axialen Richtung AR aufeinander zu bewegt.

Im nächsten Schritt c) werden die LED-Baugruppe 2 und der Grundkörper 9 weiter (in axialer Richtung) aufeinander zu bewegt, bis schließlich die Rückseite 24 der LED 3 auf der Oberseite 15 des Grundkörpers 9, die hier einen Anschlag 31 für die LED 3 ausbildet, anliegt, vgl. Teilabbildung (3). In der erreichten Endposition ragen die Endabschnitte 5a, 6a der Anschlussbeine 5, 6 aus hinteren Kanalöffnungen 13b, 14b der Kanäle 13, 14 aus dem Grundkörper 9 heraus. Die Endposition kann durch Kleben zwischen der Rückseite 24 der LED 3 und der Oberseite 15 des Grundkörpers 9 fixiert werden; wenn eine Führungsaufnahme vorhanden ist (nicht dargestellt in Fig. 5, vgl. aber z.B. Fig. 1 oder Fig. 3) ist durch Presssitz meist bereits eine ausreichende Fixierung gegeben.

Auf den Schritt c) folgen in beliebiger Reihenfolge die Schritte d) und e), wie in Teilabbildung (4) dargestellt. In Schritt d) wird hier auf einen konischen Teil 20a der Seitenfläche 20 des Grundkörpers 9 ein Metallring 11 von unten aufgeschoben bzw. aufgepresst, wobei der Endabschnitt 6a des zweiten Anschlussbeins 6 zwischen dem Metallring 11 (bzw. dessen Innenseite 11a) und der Seitenfläche 20 eingeklemmt wird. In Schritt e) wird in die hintere Kanalöffnung 13b des ersten Kanals 13 (die hier mit einem Nadelaufnahmeraum 19 ausgebildet bzw. gegenüber dem übrigen ersten Kanal 13 erweitert ist) eine Metallnadel 12 eingeführt bzw. eingepresst, wobei zwischen der Außenseite 12a der Metallnadel 12 und der Innenseite 13c des ersten Kanals 13 das erste Anschlussbein 5 bzw. dessen Endabschnitt 5a eingeklemmt wird. Etwaige verbleibende Überstände (herausragende Teile) 32 der Endabschnitte 5a, 6a sollten entfernt werden, beispielsweise abgeschnitten werden (letzteres nicht näher dargestellt). Nach den Schritten d) und e) ist die Lichtquelle 1 vollständig montiert, und insbesondere die Basis-Baugruppe 10 mit Grundkörper 9, Metallnadel 12 und Metallring 11 vollständig.

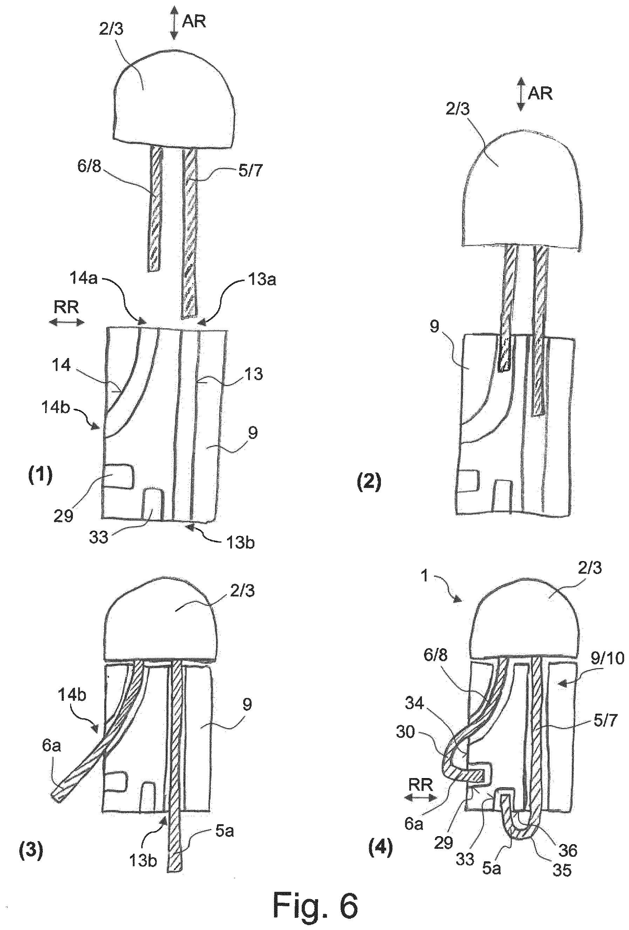

Die **Fig. 6** erläutert anhand einer Folge von Teilabbildungen (1), (2), (3) und (4) eine zweite Variante eines erfindungsgemäßen Verfahrens zur Montage einer Lichtquelle gemäß der Erfindung, insbesondere einer erfindungsgemäßen Lichtquelle wie in Fig. 4 dargestellt; die in Fig. 6 dargestellte Lichtquelle ist dabei beispielhaft zu verstehen, und erläutert Montageschritte im Falle der Verwendung von seitlicher Hilfsausnehmung und/oder unterer Hilfsausnehmung.

Die Schritte a), b) und c), illustriert in den Teilabbildungen (1), (2) und (3) entsprechen im Wesentlichen den anhand von Fig. 5 erläuterten, entsprechenden Schritten a), b) und c). Jedoch ist der Grundkörper 9 hier etwas anderes aufgebaut und weist an der Seitenfläche 20 die seitliche Hilfsausnehmung 29 auf, und an der Unterseite 18 die untere Hilfsausnehmung 33. Am Ende von Schritt c) ragen wiederum die Endabschnitte 5a, 6a aus den hinteren Kanalöffnungen 13b, 14b aus dem Grundkörper 9 heraus.

Auf den Schritt c) folgen in beliebiger Reihenfolge die Schritte d') und e'), wie in Teilabbildung (4) dargestellt. Im Schritt d') wird der Endabschnitt 6a des zweiten Anschlussbeins 6 der LED-Baugruppe 2 in die seitliche Hilfsausnehmung 29 eingesteckt. Dabei bleibt ein Teil 30 des Endabschnitts 6a außerhalb des Grundkörpers 9 und liegt frei zugänglich für eine elektrische Kontaktierung, etwa mittels einer Fassung eines Anwendungsgeräts (beispielsweise eines Orthoskops, nicht näher dargestellt). Der Teil 30 des Endabschnitts 6a liegt hier beabstandet vor dem darunterliegenden Seitenflächenabschnitt 34, und der Endabschnitt 6a reicht auch nicht ganz bis zum Grund der seitlichen Hilfsausnehmung 29, so dass der Teil 30 beim elektrischen Kontaktieren etwas elastisch federn kann, nämlich etwas nach radial innen eingedrückt werden kann. Im Schritt e') wird der Endabschnitt 5a des ersten Anschlussbeins 7 in die untere Hilfsausnehmung 33 eingesteckt. Dabei bleibt ein Teil 35 des Endabschnitts 5a außerhalb des Grundkörpers 9 und liegt frei zugänglich für eine elektrische Kontaktierung. Der Teil 35 des Endabschnitts 5a liegt hier beabstandet vor dem darunterliegenden Unterseitenabschnitt 36, und reicht auch nicht ganz bis zum Grund der unteren Hilfsausnehmung 33, so dass der Teil 35 beim elektrischen Kontaktieren etwas elastisch federn kann, nämlich etwas nach axial innen eingedrückt werden kann. Nach den Schritten d') und e') ist die Lichtquelle 1 vollständig montiert.

### Bezugszeichenliste

- 1: Lichtquelle
- 2: LED-Baugruppe
- 3: LED
- 4: Kunststoffkörper (LED)
- 5: erstes Anschlussbein (LED-Baugruppe)
- 5a: Endabschnitt (erstes Anschlussbein der LED-Baugruppe)
- 6: zweites Anschlussbein (LED-Baugruppe)
- 6a: Endabschnitt (zweites Anschlussbein der LED-Baugruppe)
- 7: erstes Anschlussbein (LED)
- 8: zweites Anschlussbein (LED)
- 9: Grundkörper
- 10: Basis-Baugruppe
- 11: Metallring
- 11a: Innenseite (Metallring)
- 12: Metallnadel
- 12a: Außenseite (Metallnadel)
- 13: erster Kanal
- 13a: vordere Kanalöffnung (erster Kanal)
- 13b: hintere Kanalöffnung (erster Kanal)
- 13c: Innenseite (erster Kanal)
- 14: zweiter Kanal
- 14a: vordere Kanalöffnung (zweiter Kanal)
- 14b: hintere Kanalöffnung (zweiter Kanal)
- 15: Oberseite
- 16: Grund (Führungsaufnahme)
- 17: Führungsaufnahme
- 18: Unterseite
- 19: Nadelaufnahmeraum
- 20: Seitenfläche
- 20a: Teil der Seitenfläche
- 22: Außengewinde
- 23: Elektronik-Bauteil
- 23a: Vorwiderstand
- 23b: Konstantstromquellen-Schaltung
- 24: Rückseite (Kunststoffkörper der LED)
- 25: Ringfläche (Grundkörper)
- 26: Aufnahme-Ausnehmung
- 27: Grund (Aufnahme-Ausnehmung)
- 28: Schulter (Grundkörper)
- 29: seitliche Hilfsausnehmung
- 30: Teil (Endabschnitt des zweiten Anschlussbeins)
- 31: Anschlag
- 32: Überstand/herausragender Teil
- 33: untere Hilfsausnehmung
- 34: Seitenflächenabschnitt
- 35: Teil (Endabschnitt des ersten Anschlussbeins)
- 36: Unterseitenabschnitt
- AR: axiale Richtung
- RR: radiale Richtung

## Patentansprüche

1. Lichtquelle (1), insbesondere für ein medizinisches Untersuchungsgerät, umfassend eine LED-Baugruppe (2) und eine Basis-Baugruppe (10), an der die LED-Baugruppe (2) befestigt ist,
wobei die LED-Baugruppe (2) eine LED (3) sowie ein erstes metallisches Anschlussbein (5), insbesondere für eine Anode der LED (3), und ein zweites metallisches Anschlussbein (6), insbesondere für eine Kathode der LED (3), umfasst,
und wobei die Basis-Baugruppe (10) einen Grundkörper (9) umfasst, wobei der Grundkörper (9) aus einem elektrisch isolierenden Material, insbesondere Kunststoff, gefertigt ist und einen ersten Kanal (13) sowie einen zweiten Kanal (14) aufweist,
wobei der erste Kanal (13) eine vordere Kanalöffnung (13a) an einer Oberseite (15) des Grundkörpers (9) aufweist, wobei die Oberseite (15) der LED (3) zugewandt ist, und eine hintere Kanalöffnung (13b) an einer Unterseite (18) des Grundkörpers (9) aufweist, wobei die Unterseite (18) der LED (3) abgewandt ist,
wobei der zweite Kanal (14) eine vordere Kanalöffnung (14a) ebenfalls an der Oberseite (15) des Grundkörpers (9) aufweist,
und wobei das erste Anschlussbein (5) in den ersten Kanal (13) und das zweite Anschlussbein (6) in den zweiten Kanal (14) eingesteckt ist,
**dadurch gekennzeichnet,**
**dass** der zweite Kanal (14) eine hintere Kanalöffnung (14b) an einer Seitenfläche (20) des Grundkörpers (9) aufweist, wobei die Seitenfläche (9) zwischen oder Oberseite (15) und der Unterseite (18) ausgebildet ist, und wobei das zweite Anschlussbein (6) aus der hinteren Kanalöffnung (14b) des zweiten Kanals (14) herausragt.

2. Lichtquelle (1) nach Anspruch 1, **dadurch gekennzeichnet, dass** die Basis-Baugruppe (10) weiterhin einen Metallring (11) umfasst, der zumindest auf einen Teil (20a) der Seitenfläche (20) aufgeschoben ist, insbesondere aufgepresst ist, wobei zwischen der Seitenfläche (20) und einer Innenseite (11a) des Metallrings (11) ein Endabschnitt (6a) des zweiten Anschlussbeins (6) eingeklemmt ist.

3. Lichtquelle (1) nach Anspruch 1, **dadurch gekennzeichnet, dass** am Grundkörper (9) eine seitliche Hilfsausnehmung (29) ausgebildet ist, und dass das zweite Anschlussbein (6) mit einem Endabschnitt (6a) aus der hinteren Kanalöffnung (14b) des zweiten Kanals (14) herausragt, und der Endabschnitt (6a) des zweiten Anschlussbeins (6) weiterhin in die seitliche Hilfsausnehmung (29) eingesteckt ist, wobei ein Teil (30) des Endabschnitts (6a) des zweiten Anschlussbeins (6) zwischen der hinteren Kanalöffnung (14b) des zweiten Kanals (14) und der seitlichen Hilfsausnehmung (29) freiliegt.

4. Lichtquelle (1) nach einem der Ansprüche 1 bis 3, **dadurch gekennzeichnet, dass** die Basis-Baugruppe (10) weiterhin eine Metallnadel (12) umfasst, die in die hintere Kanalöffnung (13b) des ersten Kanals (13) eingeschoben ist, insbesondere eingepresst ist, wobei zwischen der Metallnadel (12) und einer Innenseite (13c) des ersten Kanals (13) ein Endabschnitt (5a) des ersten Anschlussbeins (5) eingeklemmt ist.

5. Lichtquelle (1) nach einem der Ansprüche 1 bis 3, **dadurch gekennzeichnet, dass** am Grundkörper (9) eine untere Hilfsausnehmung (33) ausgebildet ist, und dass das erste Anschlussbein (5) mit einem Endabschnitt (5a) aus der hinteren Kanalöffnung (13b) des ersten Kanals (13) herausragt, und der Endabschnitt (5a) des ersten Anschlussbeins (5) weiterhin in die untere Hilfsausnehmung (33) eingesteckt ist, wobei ein Teil (35) des Endabschnitts (5a) des ersten Anschlussbeins (5) zwischen der hinteren Kanalöffnung (13b) des ersten Kanals (13) und der unteren Hilfsausnehmung (33) freiliegt.

6. Lichtquelle (1) nach einem der vorhergehenden Ansprüche, **dadurch gekennzeichnet, dass** im Grundkörper (9) hinter der LED (3) eine Aufnahme-Ausnehmung (26) ausgebildet ist, wobei die Aufnahme-Ausnehmung (26) durch die LED (3) zumindest teilweise abgedeckt ist,
insbesondere wobei die vordere Kanalöffnung (13a) des ersten Kanals (13) und die vordere Kanalöffnung (14a) des zweiten Kanals (14) in die Aufnahme-Ausnehmung (26) münden.

7. Lichtquelle (1) nach einem der vorhergehenden Ansprüche, **dadurch gekennzeichnet,**
**dass** die LED-Baugruppe (2) weiterhin ein Elektronik-Bauteil (23) umfasst, insbesondere wobei das Elektronik-Bauteil (23) als Konstantstromquellen-Schaltung (23b) oder als Vorwiderstand (23a) ausgebildet ist,
und **dass** das Elektronik-Bauteil (23) zwischen der LED (3) und wenigstens einem der Anschlussbeine (5, 6) angeschlossen ist.

8. Lichtquelle (1) nach einem der vorhergehenden Ansprüche, **dadurch gekennzeichnet, dass** der Grundkörper (9) eine Führungsaufnahme (17), insbesondere becherförmige Führungsaufnahme (17), für die LED (3) ausbildet, in die die LED (3) eingeschoben ist, insbesondere eingepresst ist.

9. Lichtquelle (1) nach einem der vorhergehenden Ansprüche, **dadurch gekennzeichnet, dass** die LED (3) an einen vorderen, der LED (3) zugewandten Teil des Grundkörpers (9) auf den Grundkörper (9) aufgeklebt ist.

10. Lichtquelle (1) nach einem der vorhergehenden Ansprüche, **dadurch gekennzeichnet, dass** der erste Kanal (13) und der zweite Kanal (14) unter einem Winkel von 45° oder weniger, bevorzugt unter einem Winkel von 30° oder weniger, zueinander verlaufen.

11. Verfahren zur Montage einer Lichtquelle (1), insbesondere einer Lichtquelle (1) nach einem der vorhergehenden Ansprüche,
mit folgenden Schritten:
a) eine LED-Baugruppe (2), umfassend eine LED (3) sowie ein erstes metallisches Anschlussbein (5), insbesondere für eine Anode der LED (3), und ein zweites metallisches Anschlussbein (6), insbesondere für eine Kathode der LED (3), wird vor einem Grundkörper (9) aus einem elektrisch isolierenden Material, insbesondere aus Kunststoff, positioniert,
wobei der Grundkörper (9) einen ersten Kanal (13) und einen zweiten Kanal (14) aufweist, wobei der erste Kanal (13) und der zweite Kanal (14) an einer Oberseite (15) des Grundkörpers (9) jeweils vordere Kanalöffnungen (13a, 14a) aufweisen, und der erste Kanal (13) eine hintere Kanalöffnung (13b) an einer Unterseite (18) des Grundkörpers (9) aufweist, die der Oberseite (15) gegenüber liegt, und der zweite Kanal (14) eine hintere Kanalöffnung (14b) an einer Seitenfläche (20) des Grundkörpers (9) aufweist, die zwischen der Oberseite (15) und der Unterseite (18) ausgebildet ist;
b) ein Endabschnitt (5a) des ersten Anschlussbeins (5) wird in die vordere Kanalöffnung (13a) des ersten Kanals (13) eingefädelt, und ein Endabschnitt (6a) des zweiten Anschlussbeins (6) wird in die vordere Kanalöffnung (14a) des zweiten Kanals (14) eingefädelt;
c) die LED-Baugruppe (2) und der Grundkörper (9) werden aufeinander zu bewegt, so dass das erste Anschlussbein (5) in den ersten Kanal (13) und gleichzeitig das zweite Anschlussbein (6) in den zweiten Kanal (14) eingeschoben wird, derart, dass das zweite Anschlussbein (6) aus der hinteren Kanalöffnung (14b) des zweiten Kanals (14) herausragt.

12. Verfahren nach Anspruch 11, **dadurch gekennzeichnet,**
**dass** nach Schritt c) der Endabschnitt (6a) des zweiten Anschlussbeins (6) aus der hinteren Kanalöffnung (14b) des zweiten Kanals (14) herausragt, und dass weiterhin vorgesehen ist ein Schritt
d) ein Metallring (11) wird zumindest auf einen Teil (20a) der Seitenfläche (20) des Grundkörpers (9) aufgeschoben, insbesondere aufgepresst, wobei der Endabschnitt (6a) des zweiten Anschlussbeins (6) zwischen der Seitenfläche (20) und einer Innenseite (11a) des Metallrings (11) eingeklemmt wird.

13. Verfahren nach Anspruch 11, **dadurch gekennzeichnet,**
**dass** nach Schritt c) der Endabschnitt (6a) des zweiten Anschlussbeins (6) aus der hinteren Kanalöffnung (14b) des zweiten Kanals (14) herausragt, und dass weiterhin vorgesehen ist ein Schritt
d') der Endabschnitt (6a) des zweiten Anschlussbeins (6), der aus der hinteren Kanalöffnung (14b) des zweiten Kanals (14) herausragt, wird in eine seitliche Hilfsausnehmung (29) des Grundkörpers (9) eingesteckt, wobei ein Teil (30) des Endabschnitts (6a) des zweiten Anschlussbeins (6) zwischen der hinteren Kanalöffnung (14b) des zweiten Kanals (14) und der seitlichen Hilfsausnehmung (29) freiliegend bleibt.

14. Verfahren nach einem der Ansprüche 11 bis 13, **dadurch gekennzeichnet, dass** weiterhin vorgesehen ist ein Schritt
e) eine Metallnadel (12) wird in die hintere Kanalöffnung (13b) des ersten Kanals (13) eingeschoben, insbesondere eingepresst, wobei der Endabschnitt (5a) des ersten Anschlussbeins (5) zwischen der Metallnadel (12) und der Innenseite (13c) des ersten Kanals (13) eingeklemmt wird, insbesondere wobei nach Schritt c) der Endabschnitt (5a) des ersten Anschlussbeins (5) aus der hinteren Kanalöffnung (13b) des ersten Kanals (13) herausragt, und nach Schritt e) ein aus der hinteren Kanalöffnung (13b) herausragender Teil (32) des Endabschnitts (5a) des ersten Anschlussbeins (5) entfernt wird, bevorzugt abgeschnitten wird.

15. Verfahren nach einem der Ansprüche 11 bis 13, **dadurch gekennzeichnet**, nach Schritt c) der Endabschnitt (5a) des ersten Anschlussbeins (5) aus der hinteren Kanalöffnung (13b) des ersten Kanals (13) herausragt,
und dass weiterhin vorgesehen ist ein Schritt
e') der Endabschnitt (5a) des ersten Anschlussbeins (5), der aus der hinteren Kanalöffnung (13b) des ersten Kanals (13) herausragt, wird in eine untere Hilfsausnehmung (33) des Grundkörpers (9) eingesteckt, wobei ein Teil (35) des Endabschnitts (5a) des ersten Anschlussbeins (5) zwischen der hinteren Kanalöffnung (13b) des ersten Kanals (13) und der unteren Hilfsausnehmung (33) freiliegend bleibt.

## Claims

1. Light source (1), in particular for a medical examination device, comprising an LED assembly (2) and a base assembly (10) to which the LED assembly (2) is attached,
the LED assembly (2) comprising an LED (3) and a first metal connection leg (5), in particular for an anode of the LED (3), and a second metal connection leg (6), in particular for a cathode of the LED (3),
and the base assembly (10) comprising a main body (9), the main body (9) being made from an electrically insulating material, in particular a plastics material, and having a first channel (13) and a second channel (14),
the first channel (13) having a front channel opening (13a) in an upper face (15) of the main body (9), the upper face (15) facing the LED (3), and a rear channel opening (13b) in a lower face (18) of the main body (9), the lower face (18) facing away from the LED (3), the second channel (14) having a front channel opening (14a) also in the upper face (15) of the main body (9),
and the first connection leg (5) being inserted into the first channel (13) and the second connection leg (6) being inserted into the second channel (14),
**characterized in that**
the second channel (14) has a rear channel opening (14b) in a side surface (20) of the main body (9), the side surface (9) being formed between the upper face (15) and the lower face (18), and the second connection leg (6) protruding from the rear channel opening (14b) of the second channel (14).

2. Light source (1) according to claim 1, **characterized in that** the base assembly (10) also comprises a metal ring (11) which is pushed, in particular pressed, at least onto a part (20a) of the side surface (20), an end portion (6a) of the second connection leg (6) being clamped between the side surface (20) and an inner face (11a) of the metal ring (11).

3. Light source (1) according to claim 1, **characterized in that** a lateral auxiliary recess (29) is formed in the main body (9), and **in that** the second connection leg (6) protrudes, by an end portion (6a), from the rear channel opening (14b) of the second channel (14), and the end portion (6a) of the second connection leg (6) is also inserted into the lateral auxiliary recess (29), a part (30) of the end portion (6a) of the second connection leg (6) between the rear channel opening (14b) of the second channel (14) and the lateral auxiliary recess (29) being exposed.

4. Light source (1) according to any of claims 1 to 3, **characterized in that** the base assembly (10) also comprises a metal needle (12) which is inserted, in particular pressed, into the rear channel opening (13b) of the first channel (13), an end portion (5a) of the first connection leg (5) being clamped between the metal needle (12) and an inner face (13c) of the first channel (13).

5. Light source (1) according to any of claims 1 to 3, **characterized in that** a lower auxiliary recess (33) is formed in the main body (9), and **in that** the first connection leg (5) protrudes, by an end portion (5a), from the rear channel opening (13b) of the first channel (13), and the end portion (5a) of the first connection leg (5) is also inserted into the lower auxiliary recess (33), a part (35) of the end portion (5a) of the first connection leg (5) between the rear channel opening (13b) of the first channel (13) and the lower auxiliary recess (33) being exposed.

6. Light source (1) according to any of the preceding claims, **characterized in that** a receiving recess (26) is formed in the main body (9) behind the LED (3), the receiving recess (26) being at least partially covered by the LED (3),
in particular the front channel opening (13a) of the first channel (13) and the front channel opening (14a) of the second channel (14) opening into the receiving recess (26).

7. Light source (1) according to any of the preceding claims, **characterized in that** the LED assembly (2) also comprises an electronic component (23), in particular the electronic component (23) being designed as a constant current source circuit (23b) or as a series resistor (23a),
and **in that** the electronic component (23) is connected between the LED (3) and at least one of the connection legs (5, 6).

8. Light source (1) according to any of the preceding claims, **characterized in that** the main body (9) forms a guide receptacle (17), in particular a cup-shaped guide receptacle (17), for the LED (3), into which receptacle the LED (3) is inserted, in particular pressed.

9. Light source (1) according to any of the preceding claims, **characterized in that** the LED (3) is glued on the main body (9) at a front part of the main body (9) facing the LED (3).

10. Light source (1) according to any of the preceding claims, **characterized in that** the first channel (13) and the second channel (14) extend relative to one another at an angle of 45° or less, preferably at an angle of 30° or less.

11. Method for assembling a light source (1), in particular a light source (1) according to any of the preceding claims, comprising the following steps:
a) an LED assembly (2), comprising an LED (3) and a first metal connection leg (5), in particular for an anode of the LED (3), and a second metal connection leg (6), in particular for a cathode of the LED (3), is positioned in front of a main body (9) made of an electrically insulating material, in particular a plastics material,
the main body (9) having a first channel (13) and a second channel (14), the first channel (13) and the second channel (14) each having a front channel opening (13a, 14a) in an upper face (15) of the main body (9), and the first channel (13) having a rear channel opening (13b) in a lower face (18) of the main body (9), which is opposite the upper face (15), and the second channel (14) having a rear channel opening (14b) in a side surface (20) of the main body (9), which is formed between the upper face (15) and the lower face (18);
b) an end portion (5a) of the first connection leg (5) is threaded through the front channel opening (13a) of the first channel (13), and an end portion (6a) of the second connection leg (6) is threaded through the front channel opening (14a) of the second channel (14);
c) the LED assembly (2) and the main body (9) are moved toward one another such that the first connection leg (5) is inserted into the first channel (13) and at the same time the second connection leg (6) is inserted into the second channel (14) such that the second connection leg (6) protrudes from the rear channel opening (14b) of the second channel (14).

12. Method according to claim 11, **characterized in that**
after step c), the end portion (6a) of the second connection leg (6) protrudes from the rear channel opening (14b) of the second channel (14), and **in that** the following step is also provided
d) a metal ring (11) is pushed, in particular pressed, at least onto a part (20a) of the side surface (20) of the main body (9), the end portion (6a) of the second connection leg (6) being clamped between the side surface (20) and an inner face (11a) of the metal ring (11).

13. Method according to claim 11, **characterized in that**
after step c), the end portion (6a) of the second connection leg (6) protrudes from the rear channel opening (14b) of the second channel (14), and **in that** the following step is also provided
d') the end portion (6a) of the second connection leg (6), which protrudes from the rear channel opening (14b) of the second channel (14), is inserted into a lateral auxiliary recess (29) in the main body (9), a part (30) of the end portion (6a) of the second connection leg (6) between the rear channel opening (14b) of the second channel (14) and the lateral auxiliary recess (29) remaining exposed.

14. Method according to any of claims 11 to 13, **characterized in that** the following step is also provided
e) a metal needle (12) is inserted, in particular pressed, into the rear channel opening (13b) of the first channel (13), the end portion (5a) of the first connection leg (5) being clamped between the metal needle (12) and the inner face (13c) of the first channel (13),
in particular, after step c), the end portion (5a) of the first connection leg (5) protruding from the rear channel opening (13b) of the first channel (13) and, after step e), a part (32) of the end portion (5a) of the first connection leg (5) protruding from the rear channel opening (13b) being removed, preferably cut off.

15. Method according to any of claims 11 to 13, **characterized in that**, after step c), the end portion (5a) of the first connection leg (5) protrudes from the rear channel opening (13b) of the first channel (13), and **in that** the following step is also provided
e') the end portion (5a) of the first connection leg (5), which protrudes from the rear channel opening (13b) of the first channel (13), is inserted into a lower auxiliary recess (33) in the main body (9), a part (35) of the end portion (5a) of the first connection leg (5) between the rear channel opening (13b) of the first channel (13) and the lower auxiliary recess (33) remaining exposed.

## Revendications

1. Source de lumière (1), destinée notamment à un appareil d'examen médical, ladite source de lumière comprenant un ensemble à LED (2) et un ensemble de base (10) auquel l'ensemble à LED (2) est fixé,
l'ensemble à LED (2) comportant une LED (3) et une première patte de raccordement métallique (5), destinée en particulier à une anode de la LED (3), et une deuxième patte de raccordement métallique (6), destinée en particulier à une cathode de la LED (3),
et l'ensemble de base (10) comprenant un corps de base (9),
le corps de base (9) étant réalisé à partir d'une matière électriquement isolante, en particulier une matière synthétique, et comportant un premier canal (13) et un deuxième canal (14),
le premier canal (13) comportant une ouverture de canal avant (13a) sur un côté supérieur (15) du corps de base (9), le côté supérieur (15) étant dirigé vers la LED (3), et une ouverture de canal arrière (13b) sur un côté inférieur (18) du corps de base (9), le côté inférieur (18) étant opposé à la LED (3),
le deuxième canal (14) comportant une ouverture de canal avant (14a) également du côté supérieur (15) du corps de base (9),
et la première patte de raccordement (5) étant enfichée dans le premier canal (13) et la deuxième patte de raccordement (6) étant enfichée dans le deuxième canal (14),
**caractérisée en ce que**
le deuxième canal (14) comporte une ouverture de canal arrière (14b) sur une surface latérale (20) du corps de base (9), la surface latérale (9) étant formée entre le côté supérieur (15) et le côté inférieur (18), et la deuxième patte de raccordement (6) faisant saillie de l'ouverture de canal arrière (14b) du deuxième canal (14) .

2. Source de lumière (1) selon la revendication 1, **caractérisée en ce que** l'ensemble de base (10) comprend en outre une bague métallique (11) qui est poussée, notamment pressée, sur au moins une partie (20a) de la surface latérale (20), une portion d'extrémité (6a) de la deuxième patte de raccordement (6) étant serrée entre la surface latérale (20) et un côté intérieur (11a) de la bague métallique (11).

3. Source de lumière (1) selon la revendication 1, **caractérisée en ce qu'**un évidement auxiliaire latéral (29) est ménagé sur le corps de base (9), et **en ce que** la deuxième patte de raccordement (6) fait saillie, avec une portion d'extrémité (6a), de l'ouverture de canal arrière (14b) du deuxième canal (14), et la portion d'extrémité (6a) de la deuxième patte de raccordement (6) est en outre enfichée dans l'évidement auxiliaire latéral (29), une partie (30) de la portion d'extrémité (6a) de la deuxième patte de raccordement (6) étant dénudée entre l'ouverture de canal arrière (14b) du deuxième canal (14) et l'évidement latéral auxiliaire (29).

4. Source de lumière (1) selon l'une des revendications 1 à 3, **caractérisée en ce que** l'ensemble de base (10) comprend en outre une aiguille métallique (12) qui est insérée, notamment pressée, dans l'ouverture de canal arrière (13b) du premier canal (13), une portion d'extrémité (5a) de la première patte de raccordement (5) étant serrée entre l'aiguille métallique (12) et un côté intérieur (13c) du premier canal (13).

5. Source de lumière (1) selon l'une des revendications 1 à 3, **caractérisée en ce qu'**un évidement auxiliaire inférieur (33) est ménagé sur le corps de base (9), et **en ce que** la première patte de raccordement (5) fait saillie, avec une portion d'extrémité (5a), de l'ouverture de canal arrière (13b) du premier canal (13), et la portion d'extrémité (5a) de la première patte de raccordement (5) est en outre enfichée dans l'évidement auxiliaire inférieur (33), une partie (35) de la portion d'extrémité (5a) de la première patte de raccordement (5) étant dénudée entre l'ouverture de canal arrière (13b) du premier canal (13) et l'évidement auxiliaire inférieur (33) .

6. Source de lumière (1) selon l'une des revendications précédentes, **caractérisée en ce qu'**un évidement de réception (26) est ménagé dans le corps de base (9) en arrière de la LED (3), l'évidement de réception (26) étant au moins partiellement recouvert par la LED (3), notamment l'ouverture de canal avant (13a) du premier canal (13) et l'ouverture de canal avant (14a) du deuxième canal (14) débouchant dans l'évidement de réception (26).

7. Source de lumière (1) selon l'une des revendications précédentes, **caractérisée en ce que**
l'ensemble à LED (2) comprend en outre un composant électronique (23), en particulier le composant électronique (23) étant conçu comme un circuit source de courant constant (23b) ou comme une résistance en série (23a), et
le composant électronique (23) est raccordé entre la LED (3) et l'une au moins des pattes de raccordement (5, 6).

8. Source de lumière (1) selon l'une des revendications précédentes, **caractérisée en ce que** le corps de base (9) forme un logement de guidage (17), notamment un logement de guidage en forme de coupelle (17), destiné à la LED (3) dans lequel la LED (3) est insérée, en particulier enfoncée.

9. Source de lumière (1) selon l'une des revendications précédentes, **caractérisée en ce que** la LED (3) est collée sur le corps de base (9) à une partie avant du corps de base (9) qui est dirigée vers la LED (3).

10. Source de lumière (1) selon l'une des revendications précédentes, **caractérisée en ce que** le premier canal (13) et le deuxième canal (14) s'étendent en formant un angle de 45° ou moins, de préférence un angle de 30° ou moins, l'un par rapport à l'autre.

11. Procédé de montage d'une source de lumière (1), notamment d'une source de lumière (1) selon l'une des revendications précédentes, ledit procédé comprenant les étapes suivantes :
a) un ensemble à LED (2) comprenant une LED (3) et une première patte de raccordement métallique (5), destinée en particulier à une anode de la LED (3), et une deuxième patte de raccordement métallique (6), destinée en particulier à une cathode de la LED (3), est positionné en avant d'un corps de base (9) en une matière électriquement isolante, en particulier en matière synthétique, le corps de base (9) comportant un premier canal (13) et un deuxième canal (14), le premier canal (13) et le deuxième canal (14) comportant chacun des ouvertures de canal avant (13a, 14a) sur un côté supérieur (15) du corps de base (9), et le premier canal (13) comportant une ouverture de canal arrière (13b) sur un côté inférieur (18) du corps de base (9), qui est opposé au côté supérieur (15), et le deuxième canal (14) comportant une ouverture de canal arrière (14b) sur une surface latérale (20) du corps de base (9) qui est formée entre le côté supérieur (15) et le côté inférieur (18) ;
b) une portion d'extrémité (5a) de la première patte de raccordement (5) est enfilée dans l'ouverture de canal avant (13a) du premier canal (13), et une portion d'extrémité (6a) de la deuxième patte de raccordement (6) est enfilée dans l'ouverture de canal avant (14a) du deuxième canal (14) ;
c) l'ensemble à LED (2) et le corps de base (9) sont déplacés l'un vers l'autre de sorte que la première patte de raccordement (5) est insérée dans le premier canal (13) et en même temps la deuxième patte de raccordement (6) est insérée dans le deuxième le canal (14) de manière que la deuxième patte de raccordement (6) fasse saillie de l'ouverture de canal arrière (14b) du deuxième canal (14) .

12. Procédé selon la revendication 11, **caractérisé en ce que**, après l'étape c), la portion d'extrémité (6a) de la deuxième patte de raccordement (6) fait saillie de l'ouverture de canal arrière (14b) du deuxième canal (14), et **en ce qu'**il est prévu l'étape suivante d) une bague métallique (11) est poussée, en particulier pressée, au moins sur une partie (20a) de la surface latérale (20) du corps de base (9), la portion d'extrémité (6a) de la deuxième patte de raccordement (6) étant serrée entre la surface latérale (20) et un côté intérieur (11a) de la bague métallique (11).

13. Procédé selon la revendication 11, **caractérisé en ce que**, après l'étape c), la portion d'extrémité (6a) de la deuxième branche de raccordement (6) fait saillie de l'ouverture de canal arrière (14b) du deuxième canal (14), et **en ce qu'**il est également prévu l'étape suivante d') la portion d'extrémité (6a) de la deuxième branche de raccordement (6), qui fait saillie de l'ouverture de canal arrière (14b) du deuxième canal (14), est enfichée dans un évidement auxiliaire latéral (29) du corps de base (9), une partie (30) de la portion d'extrémité (6a) de la deuxième patte de raccordement (6) restant dénudée entre l'ouverture de canal arrière (14b) du deuxième canal (14) et l'évidement auxiliaire latéral (29).

14. Procédé selon l'une des revendications 11 à 13, **caractérisé en ce qu'**il est en outre prévu l'étape suivante
e) une aiguille métallique (12) est poussée, en particulier pressée, dans l'ouverture de canal arrière (13b) du premier canal (13), la portion d'extrémité (5a) de la première patte de raccordement (5) étant serrée entre l'aiguille métallique (12) et le côté intérieur (13c) du premier canal (13), en particulier après l'étape c) la portion d'extrémité (5a) de la première patte de raccordement (5) faisant saillie de l'ouverture de canal arrière (13b) du premier canal (13), et après l'étape e) une partie (32), faisant saillie de l'ouverture de canal arrière (13b), de la portion d'extrémité (5a) de la première patte de raccordement (5) étant supprimée, de préférence coupée.

15. Procédé selon l'une des revendications 11 à 13, **caractérisé en ce que**, après l'étape c), la portion d'extrémité (5a) de la première patte de raccordement (5) fait saillie de l'ouverture de canal arrière (13b) du premier canal (13), et **en ce qu'**il est en outre prévu l'étape suivante
e') la portion d'extrémité (5a) de la première patte de raccordement (5), qui fait saillie de l'ouverture de canal arrière (13b) du premier canal (13), est enfichée dans un évidement auxiliaire inférieur (33) du corps de base (9), une partie (35) de la portion d'extrémité (5a) de la première patte de raccordement (5) restant dénudée entre l'ouverture de canal arrière (13b) du premier canal (13) et l'évidement auxiliaire inférieur (33).
